# EUROPEAN PATENT APPLICATION

(11) **EP 4 752 931 A1**
(43) Date of publication of application: **03.06.2026**
(21) Application number: 24460039.1
(22) Date of filing: 29.11.2024
(51) Int. Cl.: H01J 37/34, C23C 14/34, H01J 37/32

(54) **BIPOLAR PULSING POWER SUPPLY FOR A PLASMA PROCESSING SYSTEM AND SUCH A SYSTEM AND METHOD**

(71) Applicant: TRUMPF Huettinger Sp. Z o. o., 05-220 Zielonka (PL)
(72) Inventor: The designation of the inventor has not yet been filed
(74) Representative: Trumpf Patentabteilung

(57) **Abstract**

A bipolar pulsing power supply (1) for a plasma processing system (10) with a first output (11) and a second output (12) the first output (11) configured to be connected to a first electrode (3) of a plasma processing chamber (7) and the second output (12) configured to be connected to a second electrode (4) of the plasma processing chamber (7), the bipolar pulsing power supply (1) is configured to:
- deliver pulsed power with a first pulsed current flow (21) to a predominant extent in a first direction from the first output (11) to the second output (12) during a first time duration (23) and
- deliver pulsed power with a second pulsed current flow (22) to a predominant extent in a second direction from the second output (12) to the first output (11) during a second time duration (24),
wherein the first pulsed current flow (21) and the second pulsed current flow (22) are independently controllable for both directions in respect to at least one of: duty cycle (25), power level (26), voltage level (27), current level (28). A plasma processing system (10) and a method for of plasma processing with such a bipolar pulsing power supply (1) are also disclosed.

## Description

The invention relates to a bipolar pulsing power supply for a plasma processing system and such a plasma processing system and to a method of plasma processing in particular with an bipolar pulsing power supply or a plasma processing system.

A bipolar pulsing power supply for a plasma processing system refers to a type of power supply used in plasma processes such as sputtering, etching, PVD, CVD or other thin-film deposition techniques. This power supply is designed to alternate between positive and negative current and voltage pulses. One characteristic of this power supply is its ability to deliver voltage pulses that alternate in polarity. Unlike unipolar systems that maintain a constant polarity, bipolar systems switch between positive and negative voltages and current directions. By using bipolar pulsing, the power supply can improve plasma stability. The alternating polarity helps reduce charge accumulation on the substrate, which is particularly beneficial in processes involving insulating materials. It also helps mitigate issues such as arcing and uneven deposition. Bipolar pulsing can lead to more uniform thin-film deposition by reducing defects caused by charge build-up and helping in redistributing the plasma evenly across the substrate. This technology is commonly used in advanced semiconductor manufacturing, optical coatings, and other applications where high-quality, precise thin films are required, such as PVD sputtering process. A PVD (Physical Vapor Deposition) sputtering process is a technique used to deposit thin films of material onto a substrate, such as a silicon wafer in the semiconductor industry or a metal part in various manufacturing applications. The process involves the ejection of atoms or molecules from a solid target material, which is then deposited onto the substrate. In a common PVD sputtering process two similar cathodes are used.

When working with two different cathode types it is hard to maintain stable output power. Different cathode materials may have different plasma voltages and impedances.

In some examples one cathode is reactive and tends more to arcing than the other cathode which is not reactive.

Nevertheless, in such cases, often a homogeneous deposition is needed.

This invention addresses the problem of inefficient and inflexible power delivery in plasma processing system. It is a further challenge to provide a bipolar pulsing power supply for a plasma processing system and such a plasma processing system operable in a great variance of different cathodes.

The problem is solved by a bipolar pulsing power supply according to claim 1. It is further solved by a plasma processing system according to claim 11. It is further solved by a method of plasma processing according to claim 15. Further aspects are disclosed in the subclaims and the description.

There is disclosed a bipolar pulsing power supply for a plasma processing system with a first output and a second output, the first output configured to be connected to a first electrode of a plasma processing chamber and the second output configured to be connected to a second electrode of the plasma processing chamber, the bipolar pulsing power supply is configured to:
- deliver pulsed power with a first pulsed current flow to a predominant extent in a first direction from the first output to the second output during a first time duration and
- deliver pulsed power with a second pulsed current flow to a predominant extent in a second direction from the second output to the first output during a second time duration.

Thereby, the first pulsed current flow and the second pulsed current flow are independently controllable for both directions in respect to at least one of: duty cycle, power level, voltage level, current level.

The duty cycle is defined as the ratio between the pulse duration, or pulse width of pulse waveform such as a rectangular waveform.

With "to a predominant extent in a certain direction" is meant that most of the current during this time period flows in this certain direction.

It is possible that during this time period also a smaller extent of current flows in the reverse direction.

This reverse current may be at least ten times smaller than the current in the "certain direction".

The duration of this reverse current may be at least ten times smaller than the current in the "certain direction".

The ability to independently control the pulsed current flow in both directions may allow for enhanced process customization, enabling optimization of plasma characteristics for specific material processing requirements.

The further described developments may individually or in combination solve one or more of the problems mentioned above even better. Further advantages are described in the following.

In a development, the bipolar pulsing power supply is configured that the pulsed current flow being additionally controllable in respect to frequency independently for both directions.

In a development, the bipolar pulsing power supply is configured that the pulsed current flow being independently controllable for both directions in respect to duty cycle and in respect to at least one of: power level, voltage level, current level.

In a development, the bipolar pulsing power supply is configured that a low frequency of switching between the first and second duration being in the range from 10 Hz to 100 kHz.

In a development, the bipolar pulsing power supply is configured that a high frequency of pulsed current flow within a time duration being in the range from 1 kHz to 500 kHz.

As the low frequency range and the high frequency range are overlapping, this should be understood in the following: the high frequency must always be equal or higher than the low frequency. So, e.g., in the case when the low frequency is 100 kHz, than the high frequency must be at least 100 kHz.

In an aspect, the bipolar pulsing power supply is configured that the high frequency during the first time duration is different from the high frequency during the second time duration.

In a development, the bipolar pulsing power supply including a pulsing unit, preferred in form of a bridge circuit, in particular an H-bridge circuit configured to enable bipolar pulsing.

In a development, the bipolar pulsing power supply is configured that a first time duration being different, e. g. longer, than the second time duration.

In a development, the bipolar pulsing power supply is configured that some of, in particular all of the pulses are followed by a reverse pulse in an opposite direction than the pulse wherein the pulse is at least one of longer or of a higher volume than the reverse pulse.

In a development, the bipolar pulsing power supply is configured that some of, in particular all of the pulses having a pulse-on-time-duration where power is delivered to the electrodes and a pulse-off-time-duration where no power is delivered to the electrodes.

In a development, the bipolar pulsing power supply is configured that some of, in particular all of the pulses having a pulse-high-time-duration where a predetermined power level is delivered to the electrodes and a pulse-low-time-duration where a predetermined lower power is delivered to the electrodes.

In an aspect, there is disclosed a plasma processing system with a bipolar pulsing power supply as described above, the first output connected to a first electrode of the plasma processing chamber and the second output connected to the second electrode of the plasma processing chamber.

In a development, the system further comprises a first electrode establishing in use a different impedance as the second electrode.

In a development, the system further comprises a first electrode being of a different material as the second electrode.

In a development, the system further comprises a plasma processing system being configured to establish during the first time duration a first plasma process, e. g. a reactive plasma process, and during the second time duration a second plasma process which is different from the first plasma process, e. g. a non-reactive plasma process.

In a development, a method of plasma processing in particular with a bipolar pulsing power supply or a plasma processing system as described here, comprises the following steps:
- deliver pulsed power with a first pulsed current flow to a predominant extent in a first direction from the first output to the second output during a first time duration and
- deliver pulsed power with a second pulsed current flow to a predominant extent in a second direction from the second output to the first output during a second time duration, wherein
- the first pulsed current flow and the second pulsed current flow are independently controllable for both directions in respect to at least one of: duty cycle, power level, voltage level, current level.

The present disclosure is illustrated by way of example and not limited in the accompanying figures in which like reference numerals indicate similar elements. Embodiments of the application will now be described with reference to the attached drawings:
Fig. 1 shows a schematic diagram of a plasma processing system featuring a bipolar pulsing power supply;
Fig. 2 to Fig. 6 each show a graphical representation of the current waveform at the outputs of a bipolar pulsing power supply.
Fig 7 shows a flow chart of the method steps.

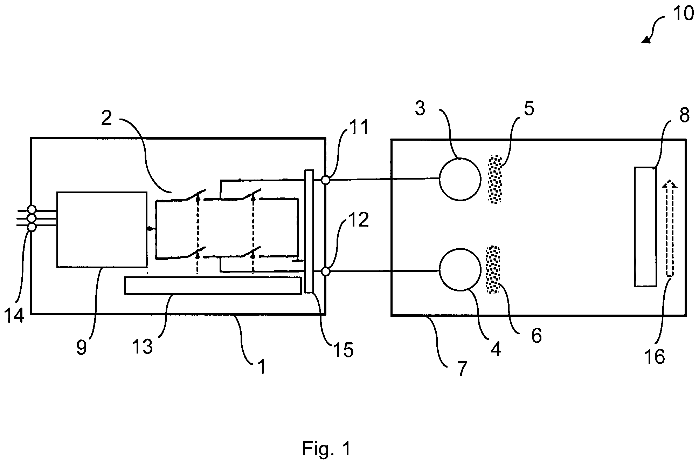

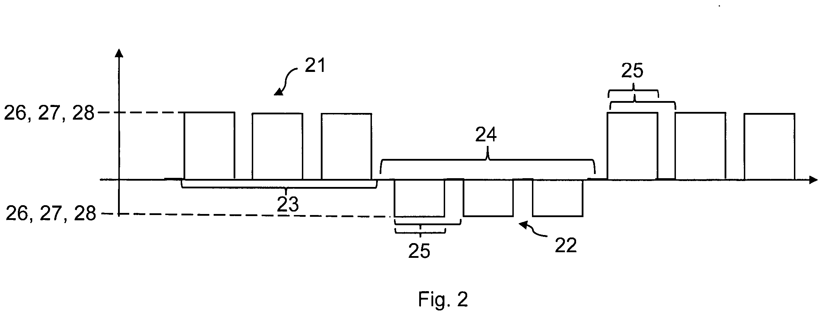

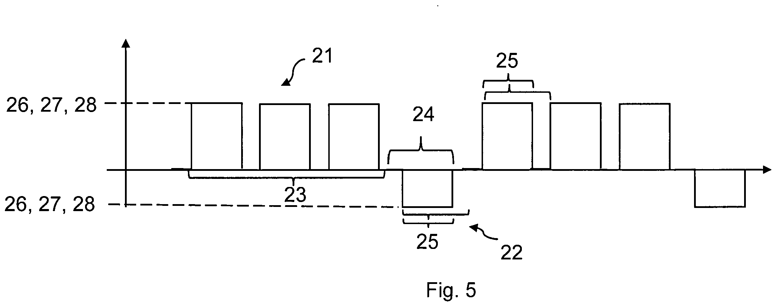

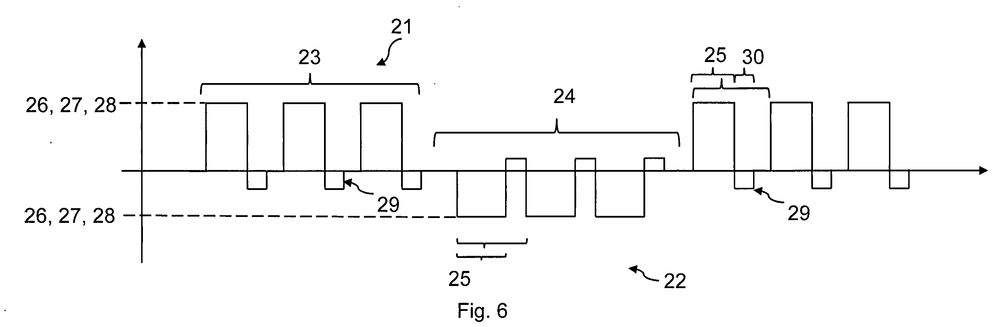

Fig. 1 shows a schematic diagram of a plasma processing system 10. The plasma processing system 10 comprises a bipolar pulsing power supply 1 and a plasma processing chamber 7. The bipolar pulsing power supply 1 includes a grid connection 14 to be connected to a power supplying grid such as a usual AC grid with 50 Hz or 60 Hz. The bipolar pulsing power supply 1 further comprises an AC/DC converter 9 connected to the grid connection 14 and configured to form a DC power out of the power delivered at the grid connection 14. Such an AC/DC converter 9 may comprise an input filter for reduction of electromagnetic interference or disturbance, a protection circuit to protect the power supply from high voltage, overcurrent, e.g., a rectifier, a power factor compensation (PFC) circuit, a buck and/or boost converter. It may be configured to work as current source or voltage source. Preferred in many plasma applications is a current source behavior. The bipolar pulsing power supply 1 further comprises a pulsing unit 2, connected Downstream of the AC/DC converter 9. The pulsing unit 2 may be embodied as a bridge circuit, preferred as a full bridge circuit. It may comprise several transistors which may be IGBT or MOSFET. The pulsing unit 2, in particular the transistors of such a pulsing unit are controlled by a control unit 13. This control unit 13 may comprise a microcontroller and/or a programmable logic device such as a FPGA, and/or a program memory and/or data memory as usual in common control units. The output of the pulsing unit 2 may deliver pulses in all forms, especially as described in the following in respect to Fig. 2 - Fig. 6. The bipolar pulsing power supply 1 may further comprise an output circuit 15, connected between the pulsing unit 2 and the first output 11 and the second output 12 of the bipolar pulsing power supply 1. The output circuit 15 may comprise an output filter, and/or protection means, and/or measuring equipment.

AC stands for "alternating current", this is a type of electrical current in which the flow of electric charge periodically reverses direction.

DC stands for "direct current", this is a type of electrical current where the flow of electric charge is in one constant direction.

A Metal-Oxide-Semiconductor Field-Effect Transistor (MOSFET) is a semiconductor device which may be advantageously used in power applications for its ability to efficiently switch and amplify electronic signals. In power applications, MOSFETs may provide high-speed switching capabilities, low on-resistance, and ease of driving with low input power, which makes them highly effective in managing power conversion and control processes.

An Insulated-Gate Bipolar Transistor (IGBT) is a semiconductor device which may be advantageously used in power electronics. It combines the characteristics of a MOSFET and a bipolar transistor, offering high input impedance and fast switching, along with the high current-carrying capability of bipolar transistors.

Different semiconductor material may be used as basis for such transistors, IGBTs or MOSFETs, such as Si, SiC, GaN.

The first output 11 and the second output 12 connect the pulsing power supply 1 to a first electrode 3 and a second electrode 4 within the plasma processing chamber 7. The first electrode 3 is associated with the generation of a first plasma 5 and the second electrode 4 with a second plasma 6. The system also includes a substrate 8. This substrate 8 is to be processed by the plasma process. It may be moved with in movement direction 16.

Fig. 2 to Fig. 6, each show a graphical representation of the current waveform at the outputs of a bipolar pulsing power supply 1.

In Fig. 2 to Fig. 6 the graph illustrates the first pulsed current flow 21 with its associated first time duration 23 and the second pulsed current flow 22 with its second time duration 24. The vertical axis indicates the current level 28. It may also be a power level 26, or a voltage level 27. Duty cycles 25 for each pulsed flow are indicated, demonstrating the intervals of power delivery.

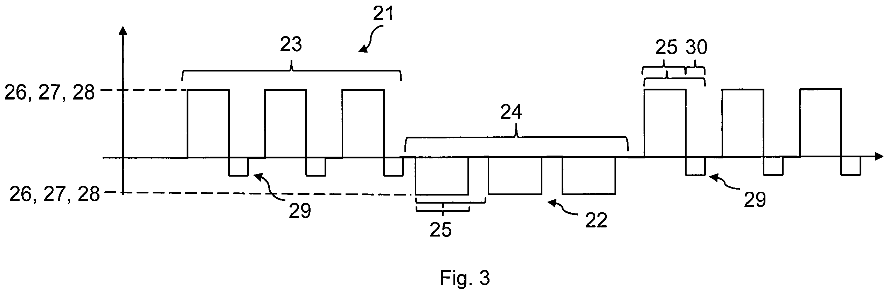

The diagram of Fig. 3, 4, 6 also includes reverse pulses 29 in both directions. They have a reverse-pulse-duration 30.

By adjusting parameters such as duty cycle 25, power level, voltage level, and current level 28, the power supply can improve the efficiency of energy transfer to the plasma, potentially leading to reduced power consumption and operational costs.

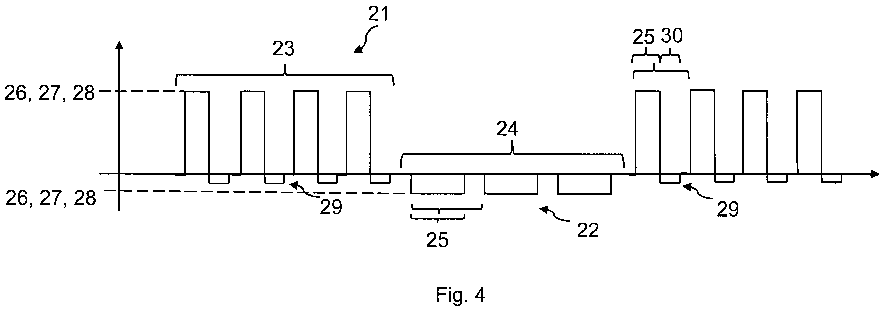

In Fig. 4, the first high frequency is higher then the second high frequency. This should be understood as an example for the individual control of the pulses during the first time duration and during the second time duration.

As mentioned in this application, there are a lot of possibilities to control individually to at least one of: duty cycle 25, power level 26, voltage level 27, current level 28. So, they might be all different during the first time duration 23 compared to those during the second time duration 24.

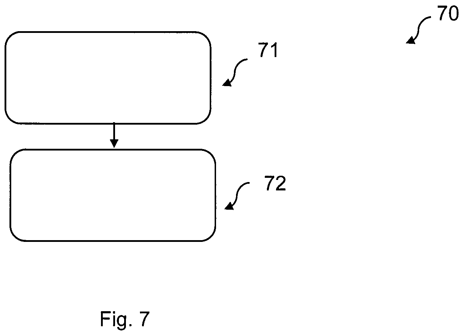

Or to control a combination of some or all of those parameters differently during the first time duration 23 compared to those during the second time duration 24. Fig. 7 shows a flow chart 70 of the method steps 71, 72.

The flow chart 70 of the method of plasma processing, in particular executed with a bipolar pulsing power supply 1 or a plasma processing system 10 as described here, comprises the following steps:
- a first delivery step 71 in which a pulsed power is delivered with a first pulsed current flow 21 to a predominant extent in a first direction from the first output 11 to the second output 12 during a first time duration 23 and
- a second delivery step 72 in which a pulsed power is delivered with a second pulsed current flow 22 to a predominant extent in a second direction from the second output 12 to the first output 11 during a second time duration 24, wherein
- the first pulsed current flow 21 and the second pulsed current flow 22 are independently controllable for both directions in respect to at least one of: duty cycle 25, power level 26, voltage level 27, current level 28.

Independent control of the pulsed current flows contributes to the versatility of the plasma processing system 10, making it suitable for a wider range of applications, from etching to deposition, by tailoring the electrical environment to the needs of different materials and processes.

The system 10 provides the advantage of enhanced performance in plasma processing by allowing independent control of pulsed current flows in both directions, optimizing the process for various applications.

The system 10 provides the advantage of reduced latency in switching between different plasma processes, enabling quicker transitions and improved efficiency in processing time.

The system 10 provides the advantage of more operative flexibility in adjusting duty cycles, power levels, voltage levels, and current levels, allowing for tailored processing conditions based on specific requirements.

The system 10 provides the advantage of improved conductive properties through the use of a bipolar pulsing power supply, which can enhance the quality and uniformity of the plasma generated.

The system 10 provides the advantage of augmented capabilities by enabling different plasma processes to be established during distinct time durations, allowing for a broader range of applications and improved process outcomes.

While the bipolar pulsing power supply 1 may be primarily associated with physical vapor deposition (PVD) processes, it offers certain advantages that can be relevant to chemical vapor deposition (CVD) systems when adapted or used in tandem with plasma-enhanced CVD (PECVD). In PECVD, plasma is used to enhance chemical reactions for film growth. Bipolar pulsing can help manage charge accumulation on insulating substrates, reducing defects like pinholes and improving overall film quality. The alternating voltage can promote more uniform plasma distribution, which in turn leads to more consistent and uniform material deposition across the substrate. Bipolar pulsing can minimize particulate formation and reduce contamination by preventing excessive sputtering or etching that can occur with unipolar systems. By adjusting the frequency and amplitude of the bipolar pulses, operators can gain finer control over the plasma characteristics, leading to more precise deposition and improved process parameters. The ability to control the electrical characteristics of the plasma allows for a wider range of materials, including sensitive or complex compounds, to be deposited efficiently and effectively without damaging the substrate.

With improved plasma density and stability, deposition rates can be increased while maintaining film quality, which can enhance throughput and process efficiency.

The capability to control the frequency of the pulsed current flow independently for both directions may allow for precise tuning of ion energy and density, which can improve the quality and uniformity of the plasma-processed materials.

Frequency control can lead to reduced sheath voltages at the electrodes, minimizing potential damage to sensitive substrates and extending the service life of the processing equipment.

By manipulating the frequency, the power supply can adapt to different plasma chemistries and reactant gases, providing flexibility in process development and optimization for advanced material fabrication.

Independent control of both duty cycle 25 and at least one of power level 26, voltage level 27, or current level 28 for each direction enhances the ability to fine-tune the ion bombardment energy, which can lead to improved selectivity and anisotropy in etching processes.

This level of control can help in achieving more consistent plasma conditions over time, contributing to repeatable and reliable process outcomes, which is critical for high-volume manufacturing environments.

The dual control mechanism can reduce the likelihood of over-processing or under-processing, thereby improving yield and reducing waste of materials and resources.

A low frequency of switching between the first and second duration may reduce the generation of unwanted harmonics in the power supply, which can lead to more stable plasma conditions and better process control.

Operating in the range from 10 Hz to 100 kHz can enhance the energy coupling to the plasma, which may enhance process rates and throughput without compromising the integrity of the processed materials.

The specified low-frequency range can be particularly beneficial for processes that require a delicate balance between etching and deposition, as it may allow for the fine-tuning of ion bombardment and chemical reactions at the substrate surface.

A high frequency of pulsed current flow within a time duration can increase the ionization efficiency of the plasma, leading to higher plasma densities and improved process performance.

Operating at high frequencies, in the range from 1 kHz to MHz, can reduce the thermal load on the substrate, which is particularly advantageous for temperature-sensitive materials and thin films.

High-frequency pulsing can enhance the dissociation of process gases, potentially leading to a more reactive plasma environment that can lower the overall energy consumption and increase the deposition or etching rates.

The inclusion of a bipolar pulsing power supply 1 with pulsing unit 2, such as a bridge circuit, such as a full bridge or an H-bridge, may allow for precise control over the direction of current flow, enabling the reversal of polarity which can be beneficial for processes that require alternating electrical fields.

A bridge circuit, such as a full bridge or an H-bridge may allow to work with wide frequency range and asymmetrical duty of output pulses.

The ability to enable bipolar pulsing can lead to improved material processing or deposition characteristics by reducing the buildup of charge on surfaces, which can enhance the uniformity and quality of coatings or treatments applied via electrochemical methods.

Having a first time duration 23 that is different from the second time duration 24 may allow for the customization of pulse profiles to match specific process requirements, which can optimize the efficiency and effectiveness of the electrochemical reactions or treatments being performed.

By adjusting the duration of pulses, the system can be tailored to accommodate different materials or chemical environments, potentially reducing energy consumption and increasing the lifespan of the electrodes.

The implementation of reverse pulses 29 following the main pulses can help in mitigating the effects of electrode polarization, which can improve the stability and consistency of the electrochemical process over time.

By ensuring that the reverse pulse 29 has a shorter reverse-pulse-duration 30 or a lower volume than the main pulse, the system can maintain a net directional effect while still benefiting from the depolarization effects, leading to more efficient material processing or treatment.

The inclusion of pulse-on-time and pulse-off-time durations may allow for thermal management of the electrodes by preventing excessive heat buildup, which can extend the operational life of the system and reduce maintenance requirements.

By controlling the power delivery to the electrodes 3, 4 with precise on and off durations, the system can achieve better control over the electrochemical reactions, leading to improved precision in material modification or deposition processes.

The ability to modulate between a high-power level and a lower power level during pulses may enable the fine-tuning of the energy input into the system, which can lead to enhanced control over the kinetics of the electrochemical reactions.

By adjusting the power levels during the pulse-high and pulse-low durations, the system can potentially reduce power consumption and increase the energy efficiency of the process, which is beneficial for both operational costs and environmental impact.

The bipolar pulsing power supply configuration may allow for precise control over the plasma characteristics by alternating the polarity, which can lead to improved process uniformity and reduced damage to the substrate being processed.

Connecting the first and second outputs to respective electrodes can enhance the efficiency of energy transfer within the plasma processing chamber, potentially leading to faster processing times and lower energy consumption.

Establishing different impedances between the first and second electrodes can optimize the distribution of the electric field within the plasma chamber, which may result in more uniform plasma density and improved treatment of the substrate.

The impedance variation between electrodes 3, 4 can be tailored to specific materials or processes, providing flexibility and adaptability to different plasma processing requirements, thereby enhancing the system's applicability to a wide range of industrial applications.

Utilizing electrodes 3, 4 made of different materials can allow for selective interaction with the plasma, potentially leading to enhanced control over chemical reactions and surface modifications of the substrate.

The material contrast between electrodes 3, 4 can be exploited to engineer specific plasma characteristics, such as ion energy distribution and radical species generation, which can improve the precision and quality of the plasma processing.

Configuring the system to establish different plasma processes during separate time durations may enable multifunctional processing within a single chamber, reducing the need for multiple processing steps and equipment, thus saving time and cost.

The ability to switch between reactive and non-reactive plasma processes can lead to a more versatile system capable of performing complex layer depositions, etching, and surface modifications without compromising process integrity or requiring substrate transfer.

When one cathode 3 is reactive and more prone to arcing, while the other cathode 4 is not, the plasma processing system 10 can further benefit from the configuration described here. This setup may allow the system 10 to conduct distinct plasma processes during separate time durations, accommodating the reactive and non-reactive nature of each cathode. By doing so, the system can effectively manage arcing tendencies, reduce potential damage, and ensure process stability. Additionally, this arrangement enhances the versatility of the system by allowing it to perform multiple functions, such as reactive and non-reactive processing, within the same chamber 7, thereby saving time and costs.

## Claims

1. A bipolar pulsing power supply (1) for a plasma processing system (10) with a first output (11) and a second output (12) the first output (11) configured to be connected to a first electrode (3) of a plasma processing chamber (7) and the second output (12) configured to be connected to a second electrode (4) of the plasma processing chamber (7), the bipolar pulsing power supply (1) is configured to:
- deliver pulsed power with a first pulsed current flow (21) to a predominant extent in a first direction from the first output (11) to the second output (12) during a first time duration (23) and
- deliver pulsed power with a second pulsed current flow (22) to a predominant extent in a second direction from the second output (12) to the first output (11) during a second time duration (24),
wherein the first pulsed current flow (21) and the second pulsed current flow (22) are independently controllable for both directions in respect to at least one of: duty cycle (25), power level (26), voltage level (27), current level (28).

2. The bipolar pulsing power supply (1) according to claim 1, wherein the pulsed current flow is additionally controllable in respect to frequency independently for both directions.

3. The bipolar pulsing power supply (1) according to any of the aforementioned claims, wherein the pulsed current flow is independently controllable for both directions in respect to at least one of: duty cycle (25), power level (26), voltage level (27), current level (28).

4. The bipolar pulsing power supply (1) according to any of the aforementioned claims, wherein the low frequency of switching between the first and second duration is in the range from 10 Hz to 100 kHz.

5. The bipolar pulsing power supply (1) according to any of the aforementioned claims, wherein the high frequency of the pulsed current flow within a time duration is in the range from 1 kHz to 500 kHz.

6. The bipolar pulsing power supply (1) according to any of the aforementioned claims, wherein the bipolar pulsing power supply (1) includes a pulsing unit (2), preferred in form of a bridge circuit (2), in particular an H-bridge circuit configured to enable bipolar pulsing.

7. The bipolar pulsing power supply (1) according to any of the aforementioned claims, wherein the first time duration (23) is different, e.g. longer, than the second time duration (24).

8. The bipolar pulsing power supply (1) according to any of the aforementioned claims, wherein some of, in particular all of the pulses is/are followed by a reverse pulse (29) in an opposite direction than the pulse wherein the pulse is at least one of a longer or of a higher volume than the reverse pulse.

9. The bipolar pulsing power supply (1) according to any of the aforementioned claims, wherein some of, in particular all of the pulses have a pulse-on-time-duration where power is delivered to the electrodes and a pulse-off-time-duration where no power is delivered to the electrodes.

10. The bipolar pulsing power supply (1) according to any of the aforementioned claims, wherein some of, in particular all of the pulses have a pulse-high-time-duration where a predetermined power level is delivered to the electrodes and a pulse-low-time-duration where a predetermined lower power is delivered to the electrodes.

11. A plasma processing system (10) with a bipolar pulsing power supply (1) according to any of the aforementioned claims, the first output (11) connected to a first electrode (3) of the plasma processing chamber (7) and the second output (12) connected to the second electrode (4) of the plasma processing chamber (7).

12. The plasma processing system (10) according to claim 11, wherein the first electrode (3) establishes in use a different impedance as the second electrode (4)

13. The plasma processing system (10) according to any of the aforementioned claims 11 or 12, wherein the first electrode (3) is of a different material as the second electrode (4).

14. The plasma processing system (10) according to any of the aforementioned claims 11 to 13, wherein the plasma processing system (10) is configured to establish during the first time duration a first plasma process, e.g. a reactive plasma process, and during the second time duration a second plasma process which is different from the first plasma process, e.g. a non-reactive plasma process.

15. Method of plasma processing in particular with a bipolar pulsing power supply (1) or a plasma processing system (10) according to any of the aforementioned claims, the method comprising the steps of:
- deliver pulsed power with a first pulsed current flow (21) to a predominant extent in a first direction from the first output (11) to the second output (12) during a first time duration (23) and
- deliver pulsed power with a second pulsed current flow (22) to a predominant extent in a second direction from the second output (12) to the first output (11) during a second time duration (24), wherein
- the first pulsed current flow (21) and the second pulsed current flow (22) are independently controllable for both directions in respect to at least one of: duty cycle (25), power level (26), voltage level (27), current level (28).
